# EUROPÄISCHE PATENTANMELDUNG

(11) **EP 2 595 218 A1**
(43) Veröffentlichungstag der Anmeldung: **22.05.2013**
(21) Anmeldenummer: 12185994.6
(22) Anmeldetag: 26.09.2012
(51) Int. Cl.: H01M 2/20, H01M 10/42, H01M 10/48, G01R 31/36

(54) **Verfahren zum Überwachen einer Batterie**

(30) Priorität: 18.11.2011 DE 102011086620
(71) Anmelder: Samsung SDI Co., Ltd., Gyeonggi-do (KR); Robert Bosch GmbH, 70442 Stuttgart (DE)
(72) Erfinder: Boehm, Andre, 70806 Kornwestheim (DE); Henrici, Fabian, 70195 Stuttgart (DE)
(74) Vertreter: Bee, Joachim

(57) **Zusammenfassung**

Es werden ein Verfahren zum Überwachen einer Batterie (10) und eine Batterie (10) zur Durchführung des Verfahrens vorgestellt. Die Batterie (10) umfasst eine Anzahl an Zellen (12, 14, 16), wobei in Kontakt mit mindestens zwei der Zellen (12, 14, 16) jeweils mindestens eine elektronische Einheit (30) zur Aufnahme einer Größe dieser Zelle (12, 14, 16) angeordnet ist, die mit einem zentralen Empfänger (22) in Kommunikation steht, wobei die mindestens eine elektronische Einheit (30) mindestens eine Kenngröße aufnimmt und diese an den zentralen Empfänger weitergibt.

## Beschreibung

Die Erfindung betrifft ein Verfahren zum Überwachen einer Batterie und eine Batterie, die zur Durchführung des Verfahrens ausgebildet ist.

### Stand der Technik

Als Batterie wird eine Zusammenschaltung mehrerer in der Regel gleichartiger galvanischer Zellen bezeichnet. Diese stellt einen elektrochemischen Energiespeicher und einen Energiewandler dar und ist zur Abgabe elektrischer Energie vorgesehen. In der Batterie wird bei der Entladung gespeicherte chemische Energie durch die elektrochemische Reaktion in elektrische Energie umgewandelt. Die Zellen der Batterie, die parallel oder in Reihe oder gemischt geschaltet sein können, sind in sogenannten Modulen angeordnet. Eines oder mehrere dieser Module, in Reihe oder parallel geschaltet, bilden die Batterie.

Bei den genannten Zellen wird zwischen Primärzellen, die nicht wiederaufladbar sind, und Sekundärzellen, die wiederaufladbar sind, unterschieden. Eine wiederaufladbaren Batterie wird auch als Akkumulator mit Akkuzellen bezeichnet. Im folgenden wird unter Batterie sowohl eine nicht wiederaufladbare als auch eine wiederaufladbare Batterie verstanden.

In Kraftfahrzeugen wird einerseits zur Bereitstellung des elektrischen Stroms für den Anlasser des Verbrennungsmotors eine sogenannte Starterbatterie verwendet, die z.B. als Bleiakkumulator ausgebildet ist. Neben der Versorgung des Anlassers versorgt die Batterie auch die anderen elektrischen Verbraucher im Fahrzeug. Zum Anlassen des Verbrennungsmotors sind kurzzeitig hohe Ströme erforderlich, die auch bei niedrigen Temperaturen bereitgestellt werden müssen. Andererseits werden in Kraftfahrzeugen, in sogenannten Elektrofahrzeugen und Hybridfahrzeugen, Batterien als Energiequellen für den Antrieb des Fahrzeugs eingesetzt. Diese werden auch als Traktionsbatterien bezeichnet.

In jedem Fall ist es erforderlich, die Funktionsfähigkeit der Batterie im Fahrzeug regelmäßig oder gar kontinuierlich zu überwachen, um einen sicheren Betrieb des Kraftfahrzeugs zu gewährleisten. Hierzu werden Kenn- bzw. Betriebsgrößen der Batterie, wie bspw. Klemmenspannung, Temperatur, Druck, insbesondere der Zellinnendruck, Strom, Impedanz usw., aufgenommen.

Es ist zu beachten, dass beim Bau von Akku-Modulen für Hybrid- und Elektrofahrzeuge bis zu 100 oder mehr einzelne Zellen zusammengeschaltet und gemeinsam verpackt werden. Dabei wird bislang nur von jeder Zelle die Spannung gemessen. Weitere Kenngrößen, wie bspw. die Temperatur, werden aber nur bei einem geringen Teil der Zellen eines Akku-Moduls gemessen. Idealerweise sollte zumindest die Temperatur jeder Zelle im Betrieb einzeln gemessen werden. Dies würde jedoch einen sehr hohen Verkabelungsaufwand bedeuten.

Aus der Druckschrift WO 2009/149690 A1 ist eine Batterie mit Batteriezellen und ein Verfahren zum Überwachen der Batterie bekannt. Die Batterie weist dabei eine Vielzahl von in Serie geschalteten Batteriezellenstapeln auf, wobei ein Batteriezellenstapel eine einzige Batteriezelle aufweisen oder aus parallel geschalteten Batteriezellen aufgebaut sein kann. Sensoren überwachen den Ladezustand einzelner Batteriezellen. Der beschriebenen Batterie ist eine Ladungsausgleichseinrichtung (cell balancing) zugeordnet, die eine Zielwerttabelle des zulässigen Ladezustands einzelner Batteriezellen aufweist. In Abhängigkeit des Ladezustands variiert die Ladungsausgleichseinrichtung den Ladungszustand. Bei Erreichen des Zielwerts für den Ladezustand einzelner Batteriezellen wird der Ladungsausgleich der Batteriezellen unterbrochen. An jeder Batteriezelle ist ein Abgriff einer Ladungsausgleichsleitung angeordnet, wobei die Ladungsausgleichsleitungen in einem Kabelbaum vereinigt sind und vorgesehenen Zellüberwachungsmodulen zugeführt werden, die ihrerseits Sensoren und Zellüberwachungsschaltkreise aufweisen, wobei diese Komponenten der Zellüberwachung gemeinsam in der Ladungsausgleichseinrichtung, räumlich von den Batteriezellen getrennt, angeordnet sind.

### Offenbarung der Erfindung

Vor diesem Hintergrund werden ein Verfahren zum Überwachen einer Batterie nach Anspruch 1 und eine Batterie mit den Merkmalen des Anspruchs 9 vorgestellt. Ausgestaltungen ergeben sich aus den abhängigen Ansprüchen und der Beschreibung.

Das vorgestellte Verfahren dient somit zur Aufnahme von Größen, wie z.B. Mess- oder Kenngrößen bzw. physikalischen Größen, bspw. in Akkumulator-Modulen, insbesondere für eine Zelltemperaturmessung in Akkumulator-Modulen von Hybrid- oder Elektrofahrzeugen. Damit wird die Erfassung einzelner Größen, wie bspw. der Zelltemperaturen, in einem viele Zellen umfassenden Modul ohne individuelle Verkabelung ermöglicht. Dies spart Kosten und ermöglicht somit eine Einzelzellentemperaturmessung, die bis jetzt aus Kostengründen nicht durchgeführt wird.

Dabei sind in Kontakt mit mindestens zwei der Zellen jeweils mindestens eine elektronische Einheit zur Aufnahme einer Größe vorgesehen. Dies bedeutet, dass in Ausgestaltung in Kontakt mit jeder der Zellen eine elektronische Einheit angeordnet ist. Alternativ kann vorgesehen sein, dass in Kontakt mit jeweils einer Zelle in jedem Modul der Batterie eine elektronische Einheit angeordnet ist. Dann entspricht die Anzahl der Module der Anzahl der elektronischen Einheiten. In Ausgestaltung kann jedem der Module mindestens eine elektronische Einheit zugeordnet sein. In Kontakt mit einer Zelle angeordnet bedeutet, dass die elektronische Einheit in oder an, regelmäßig direkt oder unmittelbar an, der zugeordneten Zelle angeordnet ist.

Die elektronischen Einheiten nehmen jeweils wenigstens eine Größe der Zelle auf, der sie zugeordnet sind. Dies kann bedeuten, dass jede elektronische Einheit ausschließlich eine Größe der zugeordneten Zelle aufnimmt. Somit gibt jede der aufgenommenen Größen ausschließlich eine Information zum Zustand der zugeordneten Zelle.

In einer besonderen Ausführung wird eine elektronische Einheit, bspw. ein Mikrochip, insbesondere ein CMOS-Chip, mit einem insbesondere thermischen Oszillator in oder an bzw. bei jeder Zelle zur Messung der Größe, insbesondere einer Temperaturmessung angeordnet. Diese sind in Ausgestaltung nur an die bereits vorhandenen Stromanschlüsse (Pole) der Zelle angeschlossen, um sich mit Energie zu versorgen. Die Frequenz des Oszillators ist insbesondere abhängig von der Temperatur. Der Oszillator setzt also die Temperatur in eine proportionale Frequenz um. Bei gleicher Temperatur in allen Zellen schwingen alle Oszillatoren mit der gleichen Frequenz.

Durch Einkoppelung der temperaturabhängigen Frequenz oder (umschaltbar bzw. zuschaltbar) einer spannungsabhängigen Frequenz oder einer Festfrequenz mit Aufmodulation des Temperatur- und/oder Spannungsmesswerts auf die Versorgungsleitungen werden die Messgrößen zum zentralen Steuergerät übertragen. Zur Unterscheidung der verschiedenen elektronischen Einheiten kann die messwertabhängige Frequenz mit einer eindeutigen Kennzeichnung bzw. ID verknüpft, bspw. moduliert, werden. Diese ID kann bspw. aus der Seriennummer der Zelle oder auch der zugeordneten Einheit oder einem beim Endmessen eingebrannten 8-bit-Wort bestehen. Im Steuergerät werden die Messsignale bspw. durch Fourieranalyse wieder getrennt und ausgewertet.

Die Übermittelung der Temperaturinformation erfolgt bspw. durch induktive oder kapazitive Einkopplung dieser Oszillation durch jede elektronische Einheit auf die gemeinsame Stromversorgung. Ein zentraler Empfänger (Mikrochip), der an der gleichen Stromversorgung wie die elektronischen Einheiten angeschlossen ist und in Kommunikation mit dieser steht, bspw. über Stromschienen des Akkupacks, koppelt die Schwingungen wieder aus, wertet sie aus und gibt die Messwerte bspw. über eine Standardsensorschnittstelle an das Steuergerät weiter. Alternativ kann dieser Empfänger auch direkt in das Steuergerat, z. B. der Batterie, angeordnet bzw. integriert sein.

Die Auswertung erfolgt in Ausgestaltung durch eine A/D-Wandlung mit darauffolgender Fourieranalyse. Da sich alle Oszillationen überlagern würden und eine Zuordnung unmöglich wäre, wird jede elektronische Einheit mit einer eigenen ID versehen, z. B. einem beim Endmessen eingebrannten 8-Bit-Wort. Diese ID wird durch die elektronische Einheit auf die Oszillationsfrequenz aufmoduliert. Dadurch entsteht eine Schwebung bei einer niedrigeren Frequenz, welche sowohl von der ID als auch von der temperaturabhängigen Trägerfrequenz abhängt. Dies erlaubt eine eindeutige Zuordnung von Messwert zu elektronischer Einheit. Es muss nur die Frequenz bestimmt werden, die Amplitude hat keinen Einfluss. Dadurch ist das Verfahren sehr störunempfindlich.

In einer alternativen Ausführung erfolgt die Auswertung mittels Aufmodulation der Sensormesswerte auf eine Festfrequenz und einer Demodulation dieser Information im Empfänger. Die Festfrequenz kann entweder über eine Quarzreferenz in der elektronischen Einheit festgelegt werden oder über eine Taktrückgewinnung aus einem von dem Empfänger, bspw. im Steuergerät, an die elektronische Einheit übertragenen Frequenzsignal, zweckmäßig ist dies insbesondere bei einer bidirektionalen Kommunikation.

Alternativ oder ergänzend können die einzelnen elektronischen Einheiten auch durch eine integrierte Energieversorgung bzw. einen integrierten Energy Harvester mit Energie versorgt werden und müssen dann über gar keine Anschlüsse verfügen. Die Signalübertragung erfolgt dann bspw. per Funk. Unter Energy Harvesting wird die Gewinnung kleiner Mengen von elektrischer Energie aus Quellen wie Umgebungstemperatur, Vibration usw. verstanden.

Alternativ oder ergänzend zu der Temperaturmessung können auch andere Kenn- bzw. Messgrößen, wie z. B. Zellinnendruck, die Zellspannung, der Zellstrom, die Zellimpedanz usw., gemessen und auf die Oszillation aufmoduliert werden.

Die Erfindung weist, zumindest in einigen der Ausführungen, erhebliche Vorteile auf:
Es wird eine Einzelmessung jeder Zelltemperatur in einem Akkumulatorpack, dies können 100 oder mehr sein, ohne dass eine zusätzliche Verdrahtung notwendig ist, ermöglicht. Dies führt zu einer erheblichen Kosteneinsparung.

Die thermischen Oszillatoren unterliegen einer sehr geringen Serienstreuung. Dadurch ist kein Abgleich erforderlich. Es müssen lediglich am Band nur elektrisch, ohne kontrollierte Temperatur und ohne Messung, unterschiedliche lDs eingebrannt werden. Dies führt ebenfalls zu einer erheblichen Kosteneinsparung.

Da kein kompliziertes Übertragungsprotokoll verwendet wird, sondern lediglich eine Schwingung eingekoppelt wird, ist die elektronische Einheit klein und kostengünstig.

Es sind keine Durchführungen für den Anschluss der elektronischen Einheit durch die Zelle erforderlich. Daraus folgt eine Kosteneinsparung und eine erhöhte Zuverlässigkeit.

Das vorgestellte Verfahren und die gezeigte Messanordnung sind grundsätzlich für alle Anwendungen einsetzbar, bei denen viele Kenngrößen, wie bspw. Temperaturen, im Betrieb gemessen werden müssen und eine Einzelverkabelung zu hohen Kosten führen würde. Besonders zweckmäßig ist der Einsatz in Batterien von Elektrofahrzeugen.

Wenn die elektronische Einheit nur die Temperatur misst, kann die Messung der Zellspannungen weiterhin im Modulsteuergerät erfolgen. Falls die elektronische Einheit auch eine Messung einer anderen Größe durchführt, kann auf die Steuergeräte in den Modulen verzichtet werden und es muss nur noch ein Steuergerät pro Batterie verbaut werden.

Eine weitere optionale Funktion der elektronischen Einheit kann das sogenannte cell balancing sein. Dabei wird über einen in der elektronischen Einheit integrierten Transistor und Widerstand ein definierter Entladestrom der Batteriezelle entzogen. Dies kann entweder über eine bidirektionale Kommunikation vom Steuergerät ausgelöst werden oder durch die elektronische Einheit selbst. Dann ist keine bidirektionale Kommunikation erforderlich.

Die elektronischen Einheiten können über einen Standby-Modus verfügen, in dem der Stromverbrauch abgesenkt wird und können entweder über eine bidirektionale Kommunikation vom Steuergerät in diesen Zustand versetzt werden oder erkennen die Betriebszustände des Kraftfahrzeugs selbstständig aus den auf der Stromleitung vorhandenen Störungen durch den Motor und/oder die Inverter.

Auch andere Messgrößen (Spannung, Temperatur, Strom, Druck, ... ) können entweder in eine Frequenz umgewandelt und durch Einkoppelung auf die Stromschienen bzw. Versorgungsleitungen an das Steuergerät übertragen werden (mehrere Größen durch abwechselnde Übertragung) oder als Digitalwert zusammen mit der ID der elektronischen Einheit auf eine Oszillation zusätzlich aufmoduliert werden.

Die optionale bidirektionale Kommunikation kann ähnlich wie die Kommunikation der elektronischen Einheit mit dem Steuergerät erfolgen, in dem die von der elektronischen Einheit ausgesandte Frequenz mit einem Befehl moduliert und an die elektronische Einheit zurückgeschickt wird. Grundsätzlich kann die Kommunikation bi- oder unidirektional erfolgen. Als Kommunikationswege können grundsätzlich die in einer Batterie vorgesehenen Stromschienen eingesetzt werden. Diese dienen demnach nicht nur zur Versorgung sondern auch als Kommunikationswege.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Kurze Beschreibung der Zeichnungen

- Figur 1: zeigt eine Ausführung der beschriebenen Batterie.
- Figur 2: zeigt in einem Graphen eine Ausführung des beschriebenen Übertragungsverfahrens.
- Figur 3: zeigt einen schematischen Aufbau eines Batteriepacks mit verteiltem Steuersystem.

### Ausführungsformen der Erfindung

Die Erfindung ist anhand von Ausführungsformen in den Zeichnungen schematisch dargestellt und wird nachfolgend unter Bezugnahme auf die Zeichnungen ausführlich beschrieben.

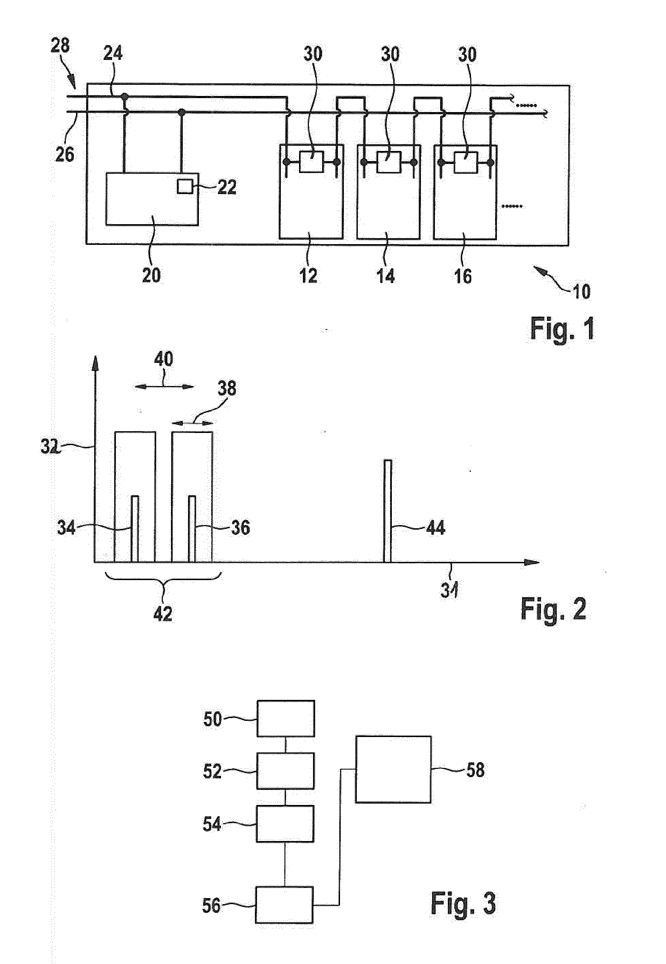

In Figur 1 ist in einer schematischen Darstellung eine Ausführung einer Batterie dargestellt, die insgesamt mit der Bezugsziffer 10 bezeichnet ist. In dieser Batterie sind eine Reihe von Zellen angeordnet, von denen der Übersichtlichkeit wegen nur eine erste Zelle 12, eine zweite Zelle 14 und eine dritte Zelle 16 gezeigt sind. Weiterhin ist ein Steuergerät 20 in der Batterie 10 vorgesehen, in dem wiederum ein zentraler Empfänger 22 angeordnet ist.

Zur Bereitstellung der durch die Zellen 12, 14 und 16 gewandelten elektrischen Energie sind Stromschienen 24 und 26 als Versorgungsleitungen vorgesehen, die an einem Anschluss 28 der Batterie 10 die elektrische Energie bereitstellen. Hierzu sind die Stromschienen 24 und 26 jeweils mit den Zellen 12, 14 und 16 verbunden. Weiterhin ist das Steuergerät 20 über die Stromschienen 24 und 26 mit den Zellen 12, 14 und 16 verbunden, so dass das Steuergerät 20 die Batteriegesamtspannung messen kann und optional mit elektrischer Energie versorgt ist.

Weiterhin ist in jeder der Zellen 12, 14 und 16 jeweils eine elektronische Einheit 30 angeordnet, die bspw. als Sensor ausgebildet und zur Aufnahme mindestens einer Größe bzw. Kenngröße der zugeordneten Zelle 12, 14 bzw. 16 dient. Diese elektronische Einheiten 30, die bspw. jeweils in einem ASIC implementiert sein können, werden ebenfalls über die Stromschienen 24 und 26 versorgt und geben die aufgenommene Kenn- bzw. Messgröße bzw. die aufgenommenen Größen über die Stromschienen 24 und 26 an den zentralen Empfänger 22 in dem Steuergerät 20 weiter. Die Größen können trägerfrequent übertragen werden. Die Übermittlung der Größen kann dabei durch induktive Einkopplung von Oszillationen, die von den elektronischen Einheiten 30 geliefert werden, erfolgen.

In der dargestellten Ausführung ist der zentrale Empfänger 22 in dem Steuergerät 20 implementiert. Alternativ kann der zentrale Empfänger 22 auch außerhalb des Steuergeräts angeordnet sein und diesem oder auch mehreren Steuergeräten zugeordnet sein. Weiterhin sind in der gezeigten Ausführung die elektronischen Einheiten 30 mit den Stromschienen 24, 26 zur Versorgung derselben und zur Weitergabe der aufgenommenen Daten verbunden. Alternativ können die elektronischen Einheiten 30 auch jeweils über eine eigene Energieversorgung verfügen. In diesem Fall können die aufgenommenen Daten auch drahtlos, bspw. über Funk, an den zentralen Empfänger 22 weitergegeben werden. In jedem Fall steht die mindestens eine elektronische Einheit 30 in Kommunikation mit dem zentralen Empfänger.

Weiterhin ist zu beachten, dass bei der in Figur 1 gezeigten Ausführung die elektronischen Einheiten 30 jeweils in der zugeordneten Zelle 12, 14 bzw. 16 angeordnet sind. Alternativ kann vorgesehen sein, dass die elektronischen Einheiten 30 an bzw. bei der zugeordneten Zelle 12, 14 bzw. 16 angeordnet sind. In jedem Fall steht die elektronische Einheit 30 in Kontakt mit der zugeordneten Zelle 12, 14 bzw. 16. In einer Ausführung können bei manchen Zellen 12, 14 bzw. 16 die zugeordneten elektronischen Einheiten in der zugeordneten Zelle 12, 14 bzw. 16 und bei anderen Zellen 12, 14 bzw. 16 an diesen Zellen 12, 14 bzw. 16 angeordnet sein. Die Wahl der Anordnung kann auch in Abhängigkeit der aufzunehmenden Kenngrößen getroffen werden.

Die Zellen 12, 14 und 16 sind bei der in Figur 1 gezeigten Ausführungsform in Reihe angeordnet. In einer alternativen Ausführung sind die Zellen 12, 14 und 16 parallel zueinander angeordnet.

In Figur 2 ist in einem Graphen ein mögliches Übertragungsverfahren wiedergegeben. In dem Graphen ist an einer Abszisse 31 die Frequenz und an einer Ordinate 32 die Amplitude in Fourieranalyse aufgetragen. Ein erster Balken 34 ist einer ersten elektronischen Einheit und ein zweiter Balken 36 einer zweiten elektronischen Einheit zugeordnet. Ein erster Doppelpfeil 38 zeigt die Variation durch die Temperatur und damit die Temperaturabhängigkeit der von den elektronischen Einheiten bereitgestellten Signale. Ein zweiter Doppelpfeil 40 zeigt die Variation durch die unterschiedliche ID der elektronischen Einheiten. Dies zeigt, dass die beiden Balken 34 und 36 im gesamten Temperaturbereich sich nicht überlagern und daher immer eine eindeutige Zuordnung des Balkens und damit der Frequenzinformation zu der entsprechenden elektronischen Einheit möglich ist.

Eine geschwungene Klammer 42 verdeutlicht die Schwebung aus ID und Trägerfrequenz. Ein dritter Balken 44 zeigt das Spektrum der Oszillation, die abhängig von der Temperatur und der Trägerfrequenz ist. Es ist dabei zu beachten, dass bei gleicher Temperatur aller Zellen sich alle Signale der elektronischen Einheiten überlagern. Dies kann durch einen Tiefpass in dem zentralen Empfänger ausgefiltert werden.

In Figur 3 ist in einer schematischen Darstellung ein Aufbau eines Batteriepacks mit verteiltem Steuersystem verdeutlicht. Die Darstellung zeigt ein erstes Steuergerät 50, ein zweites Steuergerät 52, ein drittes Steuergerät 54 und ein viertes Steuergerät 56. Die Steuergeräte 50, 52, 54 und 56 sind miteinander verbunden. Jedes dieser Steuergeräte 50, 52, 54 und 56 ist einem Modul, der beispielsweise mehreren Zellen enthält, zugeordnet. Alle Module zusammen bilden die Batterie.

Weiterhin zeigt die Darstellung ein zentrales Steuergerät 58, das mit dem vierten Steuergerät 56 verbunden ist. Auf diese Weise erhält das zentrale Steuergerät 58 Informationen bzw. Daten von allen Steuergeräten 50, 52, 54 und 56. Diese Anordnung stellt ein sogenanntes "Distributed System" bzw. eine "Dasy Chain" dar.

In einer alternativen Ausführung kann das zentrale Steuergerät 58 auch direkt mit allen Steuergeräten 50, 52, 54 und 56 verbunden sein.

## Patentansprüche

1. Verfahren zum Überwachen einer Batterie (10), die eine Anzahl an Zellen (12, 14, 16) umfasst, wobei in Kontakt mit mindestens zwei der Zellen (12, 14, 16) jeweils mindestens eine elektronische Einheit (30) zur Aufnahme einer Größe dieser Zelle (12, 14, 16) angeordnet ist, die mit einem zentralen Empfänger (22) in Kommunikation steht, wobei die mindestens zwei elektronischen Einheiten (30) mindestens eine Größe aufnehmen und diese an den zentralen Empfänger (22) weitergeben.

2. Verfahren nach Anspruch 1, bei dem mindestens eine der elektronischen Einheiten (30) eine Temperatur aufnimmt.

3. Verfahren nach Anspruch 1 oder 2, bei dem mindestens eine der elektronischen Einheiten (30) eine andere vorgebbare Messgröße aufnimmt.

4. Verfahren nach einem der Ansprüche 1 bis 3, bei dem zur Aufnahme der Temperatur und/oder der anderen Messgröße ein Oszillator eingesetzt wird.

5. Verfahren nach einem der Ansprüche 1 bis 4, bei dem die Größen trägerfrequent übertragen werden.

6. Verfahren nach einem der vorhergehenden Ansprüche, bei dem die Übermittlung der Größen durch induktive Einkopplung von Oszillationen, die von den elektronischen Einheiten (30) geliefert werden, erfolgt.

7. Verfahren nach einem der Ansprüche 1 bis 6, bei dem die mindestens eine aufgenommene Größe mit einer ID verknüpft wird, bevor diese an den zentralen Empfänger (22) weitergegeben wird.

8. Verfahren nach einem der Ansprüche 1 bis 7, bei dem eine Auswertung der weitergegebenen Größen mittels Fourieranalyse erfolgt.

9. Verfahren nach einem der Ansprüche 1 bis 8, bei dem Stromschienen (24, 26) der Batterie (10) zur Weitergabe der Größen verwendet werden.

10. Batterie mit einer Anzahl an Zellen (12, 14, 16), bei der in Kontakt mit mindestens zwei der Zellen (12, 14, 16) jeweils mindestens eine elektronische Einheit (30) zur Aufnahme einer Größe dieser Zelle (12, 14, 16) angeordnet ist, die in Kommunikation mit einem zentralen Empfänger (22) steht.

11. Batterie nach Anspruch 10, bei der innerhalb mindestens zwei der Zellen (12, 14, 16) jeweils mindestens eine elektronische Einheit (30) angeordnet ist.

12. Batterie nach Anspruch 10 oder 11, bei der der zentrale Empfänger (22) in einem Steuergerät (20, 50, 52, 54, 56) der Batterie (10) implementiert ist.

13. Batterie nach einem der Ansprüche 10 bis 12, bei der die mindestens zwei elektronischen Einheiten (30) über Stromschienen (24, 26) der Zellen (12, 14, 16) der Batterie (10) mit dem zentralen Empfänger (22) verbunden sind.

14. Batterie nach einem der Ansprüche 10 bis 13, bei dem die mindestens zwei elektronischen Einheiten (30) über eine eigene Energieversorgung verfügen.

15. Batterie nach einem der Ansprüche 10 bis 14, bei der mindestens eine der mindestens zwei elektronischen Einheiten (30) dazu ausgebildet ist, einen Ladungsausgleich, insbesondere ein cell balancing durchzuführen.

16. Batterie nach einem der Ansprüche 10 bis 15, bei der die elektrische Einheit (30) einen Mikrochip mit einem Oszillator, insbesondere einem thermischen Oszillator, umfasst.
